# EUROPÄISCHE PATENTSCHRIFT

(11) **EP 1 818 981 B1**
(45) Veröffentlichungstag und Bekanntmachung des Hinweises auf die Patenterteilung: **15.10.2008**
(21) Anmeldenummer: 07002030.0
(22) Anmeldetag: 31.01.2007
(51) Int. Cl.: H01L 23/373

(54) **Leistungshalbleitermodul mit Kontakteinrichtung**
Power semiconductor modul with contact arrangement
Module de puissance semiconducteur avec dispositif de contact

(30) Priorität: 13.02.2006 DE 102006006422
(43) Veröffentlichungstag der Anmeldung: 15.08.2007
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(56) Entgegenhaltungen:
- EP-A1- 0 487 365
- DE-A1-9102004 025 60
- US-A- 3 683 318

## Beschreibung

Die Erfindung beschreibt ein Leistungshalbleitermodul, vorzugsweise in Druckkontaktausführung, mit steuerbaren und / oder ungesteuerten Leistungshalbleiterbauelementen. Einen ersten Ausgangspunkt der Erfindung bilden druckkontaktierte Leistungshalbleitermodule wie sie beispielhaft aus der DE 42 37 632 A1 bekannt sind.

Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.

Ebenfalls bekannt sind Leistungshalbleitermodule, gemäß der DE 10 2004 025 609 A1. Hier wird ein Leistungshalbleitermodul in Drei- Phasen-Brückenschaltungstopologie offenbart mit fünf Lastanschlusselementen, je zwei Gleichstromanschlusselemente für die Anbindung an einen Zwischenkreis und je drei Wechselstromlastanschlusselementen für die drei Ausgangsphasen.

Die US 3,683,318 offenbart ein elektronisches Bauteil mit einer Kontakteinrichtung mit einem Lastanschlusselement, einem externen Kontaktelement und einem Anschlussverbinder, welcher als flächiger Metallformkörper mit mindestens einem federnd ausgestalteten, lateral zur Basisfläche des Metallformkörpers gebogenen Arm ausgestaltet ist. Weiterhin ist die Auflagefläche dieses Armes durch eine speziell ausgestaltete Struktur und durch eine ihr zugeordnete spezielle Struktur am Gehäuse des Bauelements gegen ein Verdrehen gesichert und gewährleistet eine sichere Justierung und Fixierung des externen Kontaktelements mit dem Lastanschlusselement.

Derartige moderne Leistungshalbleitermodule weisen trotz ihrer geringen Baugröße ihrem geringen Gewicht und der damit verbundenen mechanischen Stabilität eine hohe Stromtragfähigkeit auf. Es ist nachteilig, dass die Kontakteinrichtung der Lastanschlusselemente derartiger Leistungshalbleitermodule durch den zu führenden Strom angepasste Anschlusseinrichtungen externer Leiter mechanischen stark belasten. Diese Belastungen entstehen hauptsächlich bei der Herstellung der mechanischen Verbindung zwischen der Anschlusseinrichtung des externen Leiters mit den Kontakteinrichtungen der Lastanschlusselemente. Herbei entstehen durch das eingeprägte Drehmoment Belastungen, die sich bis zu den Verbindungen der Lastanschlusselemente mit den Leiterbahnen des Substrats vorsetzen und diese schädigen können. Auch können Biegemomente, die im Betrieb beispielhaft durch Temperaturwechsel auftreten, diese Verbindungen stark belasten.

Der Erfindung liegt die Aufgabe zugrunde ein Leistungshalbleitermodul vorzustellen, wobei Biege- und Drehmomente auf die Kontakteinrichtungen der Lastanschlusselemente verringert werden.

Der erfinderische Gedanke geht aus von einem Leistungshalbleitermodul beispielhaft in Druckkontaktausführung zur Anordnung auf einem Kühlbauteil mit mindestens einem Substrat, mindestens einem Leistungshalbleiterbauelementen, beispielhaft einem bipolaren Transistor, einem Gehäuse und nach außen führenden Last- und Steueranschlusselementen. Das Substrat selbst weist einen Isolierstoffkörper auf und auf dessen erster, dem Inneren des Leistungshalbleitermoduls zugewandten Hauptfläche Leiterbahnen mit Lastpotential.

Das erfindungsgemäße Leistungshalbleitermodul weist weiterhin Lastanschlusselemente jeweils ausgebildet als ein vorzugsweise bandartiger Metallformkörper auf. Diese stellen die elektrisch leitende, schaltungsgerechte, Verbindung von einem externen Leiter zu mindestens einer Leiterbahn des Substrats, oder auch direkt zu mindestens einem Leistungshalbleiterbauelement, her.

Weiterhin weist jedes Lastanschlusselement mindestens eine Kontakteinrichtung für diese externe elektrische Verbindung mit einer Anschlusseinrichtung des Leiters der Stromzu- oder -abführung auf. Erfindungsgemäß ist daher zwischen eine Anschlusseinrichtung des externen Leiters und der Kontakteinrichtungen des Lästanschlusselements ein zusätzlicher Metallformkörper flächig angeordnet. Der Metallformkörper ist derart angeordnet, dass eine Verdrehung um seine Hochachse nicht oder nur um wenige, maximal 10, Grad möglich ist.

Derart ausgebildete Leistungshalbleitermodule weisen auf Grund des zusätzlichen Metallformkörpers zwischen der Kontakteinrichtung eines Lastanschlusselements und der Anschlusseinrichtung des externen Leiters geringere Belastungen der modulinternen Verbindungen der Lastanschlusselemente auf. Der Metallformkörper nimmt hierzu einen wesentlichen Anteil des Drehmoments bei der Befestigung des externen Leiters auf. Im Betrieb werden Biegemomente mittels dieses zusätzlichen Metallformkörpers auf das Gehäuse abgeleitet und verringern somit ebenfalls die Belastungen der modulinternen Verbindungen.

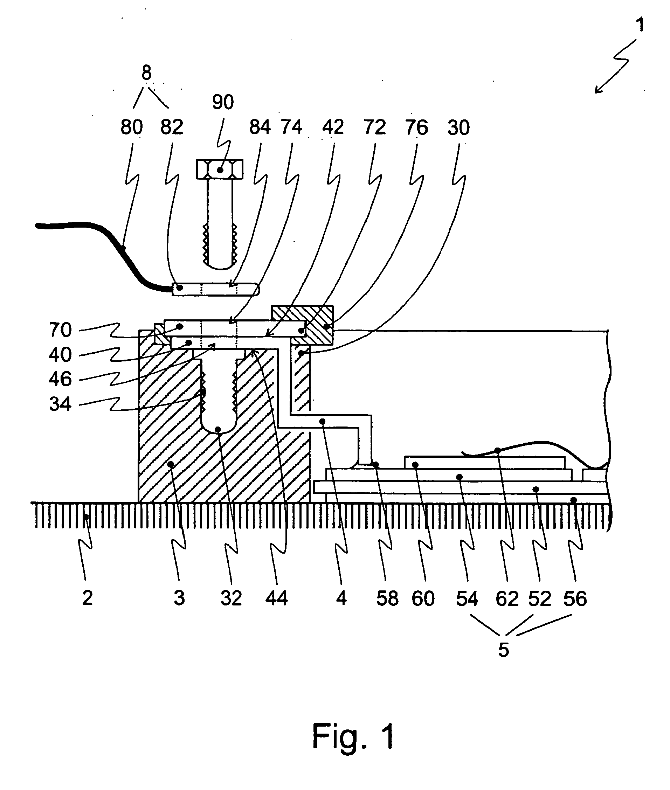

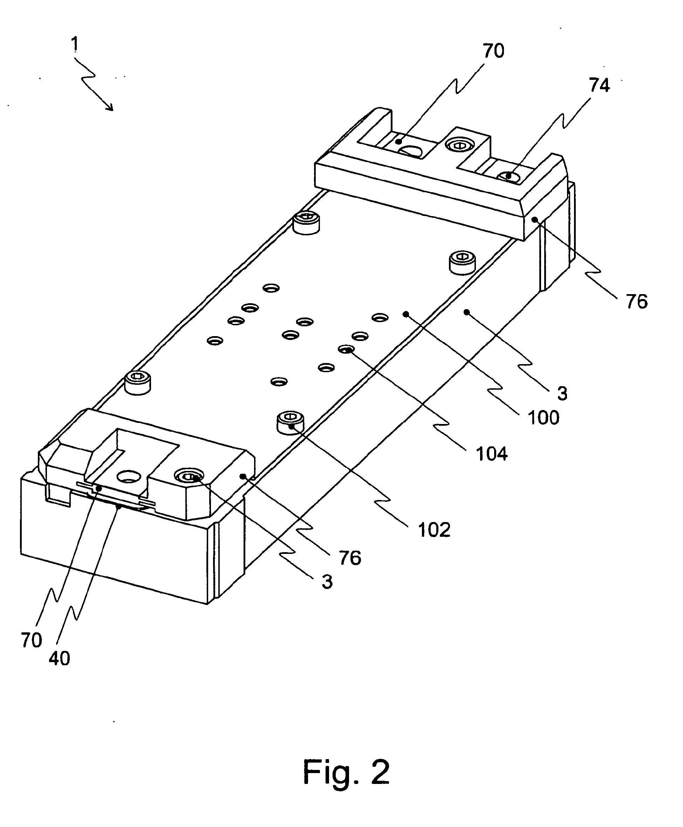

Die erfinderische Lösung wird an Hand der Ausführungsbeispiele der Fig. 1 und 2 weiter erläutert.

Fig. 1 zeigt einen Teilschnitt durch ein erfindungsgemäßes Leistungshalbleitermodul.

Fig. 2 zeigt eine dreidimensionale Darstellung eines erfindungsgemäßen Leistungshalbleitermoduls.

Fig. 1 zeigt einen Schnitt durch ein erfindungsgemäßes Leistungshalbleitermodul (1). Dieses weist ein Gehäuse (3) auf, das mindestens ein Substrat (5) umschließt. Dieses wiederum weist einen Isolierstoffkörper (52), vorzugsweise eine Isolierkeramik, wie Aluminiumoxid oder Aluminiumnitrit auf.

Auf der, dem Inneren des Leistungshalbleitermoduls (1) zugewandten, ersten Hauptfläche weist das Substrat (5) eine in sich strukturierte Metallkaschierung auf. Die einzelnen Abschnitte dieser vorzugsweise als Kupferkaschierung ausgestalteten Metallkaschierung bilden hierbei die Leiterbahnen (54) des Leistungshalbleitermoduls (1) aus. Die zweite Hauptfläche des Substrats (5) weist gemäß dem Stand der Technik eine nicht strukturierte Kupferkaschierung (56) auf.

Auf den Leiterbahnen (54) des Substrats (5) sind steuerbare und / oder ungesteuerte Leistungshalbleiterbauelemente (60) wie beispielhaft IGBTs (insulated gate bipolar Transistor) mit jeweils antiparallel geschalteten Freilaufdioden, oder MOS-FETs angeordnet. Diese sind schaltungsgerecht mit weiteren Leiterbahnen (54), beispielhaft mittels Drahtbondverbindungen (62), verbunden.

Das eine dargestellte Lastanschlusselement (40) dient der externen Verbindung der leistungselektronischen Schaltung im Inneren des Leistungshalbleitermoduls (1). Hierzu ist das Lastanschlusselement (40) als bandartiger Metallformkörper ausgebildet. Das Lastanschlusselement (40) ist hier stumpf auf die zugeordnete Leiterbahn (54) des Substrats (5) gelötet. Im weiteren Verlauf des Lastanschlusselements wird dieses im Gehäuse geführt, ohne direkt an Teilen der Gehäusewandung anzuliegen. Die Kontakteinrichtung (40) des Lastanschlusselements (4) liegt auf einem zugeordneten Abschnitt des Gehäuses zumindest teilweise auf. Vorzugsweise ebenfalls vorhandene Hilfsanschlusselemente sind aus Gründen der Übersichtlichkeit in dieser Schnittzeichnung nicht dargestellt.

Die äußeren Anschlüsse des Leistungshalbleitermoduls erfolgen mittels mindestens eines externen Leiters (8) pro Lastanschlusselement (40), wobei dem Leiter (8) mindestens eine Anschlusseinrichtung (82) zugeordnet ist. Der Leiter (8) weist weiterhin beispielhaft einen Drahtanschluss (80) oder eine Verschienung mittels flächiger Metallformkörper auf. Erfindungsgemäß ist zwischen der Anschlusseinrichtung (82) des externen Leiters (8) und der Kontakteinrichtungen (40) des Lastanschlusselements (4) ein zusätzlicher Metallformkörper (70) angeordnet ist. Dieser Metallformkörper (70) überragt hier die Kontaktfläche (42) der Kontakteinrichtungen (40) des Lastanschlusselements (4) in mindestens eine laterale Richtung, vorzugsweise in Richtung des Modulinneren. Dieser die Kontaktfläche überragende Teil (72) des Metallformkörpers (70) kann sich auf einem Teil des Gehäuses (3) abstützen.

Es ist besonders bevorzugt, wenn der Metallformkörper (70) eine größere Dicke als die Kontakteinrichtungen (40) des Lastanschlusselements (4) aufweist. Zur Anordnung des Metallformkörpers (70) auf dem Gehäuse ist es zudem vorteilhaft, wenn der Metallformkörper (70) teilweise in eine Kunststofffassung (76) eingebettet ist. In dieser Ausgestaltung stützt sich der Metallformkörper (70) über die Kunststofffassung (76) auf mehreren Teilen (30) des Gehäuses (3) ab.

Zur Verbindung der Anschlusseinrichtung (82) des externen Leiters (8) und der Kontakteinrichtung (40) des Lastanschlusselements (4) ist eine Schraube (90) vorgesehen, deren zugeordnete Gewindeaufnahme (34) in einer Ausnehmung (32) des Gehäuses (3) angeordnet ist. Um eine Krafteinleitung auf den Lastanschluss möglichst gering zu halten ist diese Gewindeaufnahme beabstandet von der Unterseite (44) der Kontakteinrichtung (40) angeordnet. Zur Anordnung dieser Schraube (90) weisen sowohl der Metallformkörper (70) als auch die Kontakteinrichtung (40) mit der Ausnehmung (32) des Gehäuses (3) fluchtende Ausnehmungen (46, 74) auf.

Fig. 2 zeigt eine dreidimensionale Darstellung eines erfindungsgemäßen Leistungshalbleitermoduls (1) in Druckkontaktierung. Dargestellt ist das Gehäuse (3) mit einer verschraubten (102) Druckeinrichtung (100) und darin angeordneten Ausnehmungen (104) zur Durchführung von als Schraubenfedern ausgebildete Hilfsanschlusselementen.

Das Leistungshalbleitermodul (1) weist an einer ersten Stirnseite ein Wechselstromlastanschlusselement und an der gegenüber liegenden Stirnseite zwei Gleichstromanschlusselemente unterschiedlicher Polarität auf. Oberhalb der Kontakteinrichtung (40) dieser Lastanschlusselemente ist jeweils eine erfindungsgemäßer Metallformkörper (70) angeordnet und in eine Kunststofffassung (76) eingebettet, wobei die jeweiligen Metallformkörper (70) der Gleichstromanschlusselemente in eine gemeinsame Kunststofffassung (76) eingebettet sind. Diese Kunststofffassungen (76) sind mit dem Gehäuse (3) des Leistungshalbleitermoduls (1) verschraubt, wodurch eine Verdrehung um die Hochachse (Schraubenachse vgl. Fig. 1), auch während des Anschraubens eines externen Leiters, nicht möglich ist.

## Patentansprüche

1. Leistungshalbleitermodul (1) mit mindestens einem Substrat (5), mindestens einem hierauf angeordneten Leistungshalbleiterbauelementen (60), einem Gehäuse (3) und nach außen führenden Lastanschlusselementen (4), wobei das Substrat (5) einen Isolierstoffkörper (52) aufweist und auf dessen erster dem Inneren des Leistungshalbleitermoduls zugewandten Hauptfläche Leiterbahnen (54) mit Lastpotential angeordnet sind
wobei die Lastanschlusselemente (4) jeweils als erster Metallformkörper mit mindestens einer Kontakteinrichtungen (40) mit Kontaktfläche (42) zur externen elektrischen Verbindung mit einer Anschlusseinrichtung (82) einer Stromzuführung (8) ausgebildet sind, und
wobei zwischen der Anschlusseinrichtung (82) des externen Leiters (8) und der Kontakteinrichtungen (40) des Lastanschlusselements (4) ein zweiter Metallformkörper (70) angeordnet ist und wobei eine Verdrehung des zweiten Metallformkörper (70) um seine Hochachse nicht oder nur um wenige, maximal 10, Grad möglich ist und
wobei die Verbindung zwischen der Anschlusseinrichtung (82) des externen Leiters (8) und der Kontakteinrichtung (40) des Lastanschlusselements (4) mittels einer Schraube (90) ausgebildet ist, deren zugeordnete Gewindeaufnahme (34) in einer Ausnehmung (32) des Gehäuses und beabstandet von der Unterseite (44) der Kontakteinrichtung (40) angeordnet ist.

2. Leistungshalbleitermodul (1) nach Anspruch 1,
wobei der Metallformkörper (70) die Kontaktfläche (42) der Kontakteinrichtungen (40) des Lastanschlusselements (4) in mindestens eine laterale Richtung überragt.

3. Leistungshalbleitermodul (1) nach Anspruch 2,
wobei der Teil (72) des Metallformkörpers (70), der die Kontaktfläche (42) der Kontakteinrichtungen (40) des Lastanschlusselements (4) überragt sich auf einem Teil (30) des Gehäuses (3) abstützt.

4. Leistungshalbleitermodul (1) nach Anspruch 1,
wobei der Metallformkörper (70) eine größere Dicke als die Kontakteinrichtungen (40) des Lastanschlusselements (4) aufweist.

5. Leistungshalbleitermodul (1) nach Anspruch 1,
wobei der Metallformkörper (70) teilweise in eine Kunststofffassung (76) eingebettet ist.

## Claims

1. Power semiconductor module (1) having at least one substrate (5), at least one power semiconductor element (60) arranged thereon, a housing (3) and load terminal elements (4) leading to the outside, wherein the substrate (5) has an insulator body (52) and, on the first main surface thereof facing the interior of the power semiconductor module, conductor tracks (54) with loading potential are arranged,
wherein the load terminal elements (4) are each constructed as a first metallic shaped body with at least one contact arrangement (40), with a contact surface (42) for the external electrical connection to a terminal arrangement (82) of a power supply (8), and
wherein between the terminal arrangement (82) of the external conductor (8) and the contact arrangements (40) of the load terminal element (4) a second metallic shaped body (70) is arranged and wherein a twisting motion of the second metallic shaped body (70) about its normal axis is either not possible or only possible by a few degrees, maximally 10, and
wherein the connection between the terminal arrangement (82) of the external conductor (8) and the contact arrangement (40) of the load terminal element (4) is in the form of a screw (90), the associated threaded receptacle (34) of which is arranged in a recess (32) of the housing and spaced apart from the underside (44) of the contact arrangement (40).

2. Power semiconductor module (1) according to Claim 1,
wherein the metallic shaped body (70) projects beyond the contact surface (42) of the contact arrangements (40) of the load terminal element (4) in at least one lateral direction.

3. Power semiconductor module (1) according to Claim 2,
wherein the part (72) of the metallic shaped body (70), which projects beyond the contact surface (42) of the contact arrangements (40) of the load terminal element (4) is supported on a part (30) of the housing (3).

4. Power semiconductor module (1) according to Claim 1,
wherein the metallic shaped body (70) has a greater thickness than the contact arrangements (40) of the load terminal element (4).

5. Power semiconductor module (1) according to Claim 1,
wherein the metallic shaped body (70) is partially embedded in a plastic holder (76).

## Revendications

1. Module semi-conducteur de puissance (1) comportant au moins un substrat (5), au moins un composant semi-conducteur de puissance (60) étant agencé dessus, un boîtier (3) et des éléments de raccordement de charge (4) conduisant vers l'extérieur, le substrat (5) comportant un corps isolant (52) et des pistes conductrices (54) avec potentiel de charge étant agencées sur la première surface principale de substrat proche de l'intérieur du module semi-conducteur de puissance,
dans lequel les éléments de raccordement de charge (4) sont chacun conçus comme un premier corps métallique mis en forme avec au moins un dispositif de contact (40) avec surface de contact (42) pour la liaison électrique externe avec un dispositif de raccordement (82) d'une alimentation en courant (8), et
dans lequel un deuxième corps métallique mis en forme (70) est agencé entre le dispositif de raccordement (82) du conducteur extérieur (8) et les dispositifs de contact (40) de l'élément de raccordement de charge (4) et une rotation du deuxième corps métallique mis en forme (70) autour de son axe vertical n'est pas possible ou est possible seulement de quelques degrés, au maximum 10, et
dans lequel la liaison entre le dispositif de raccordement (82) du conducteur externe (8) et le dispositif de contact (40) de l'élément de raccordement de charge (4) est conçue au moyen d'une vis (90) dont le logement taraudé associé (34) est agencé dans un évidement (32) du boîtier et à une certaine distance du dessous (44) du dispositif de contact (40).

2. Module semi-conducteur de puissance (1) selon la revendication 1,
dans lequel le corps métallique mis en forme (70) dépasse de la surface de contact (42) des dispositifs de contact (40) de l'élément de raccordement de charge (4) dans au moins une direction latérale.

3. Module semi-conducteur de puissance (1) selon la revendication 2,
dans lequel la partie (72) du corps métallique mis en forme (70) qui dépasse de la surface de contact (42) des dispositifs de contact (40) de l'élément de raccordement de charge (4) s'appuie sur une partie (30) du boîtier (3).

4. Module semi-conducteur de puissance (1) selon la revendication 1,
dans lequel le corps métallique mis en forme (70) a une plus grande épaisseur que les dispositifs de contact (40) de l'élément de raccordement de charge (4).

5. Module semi-conducteur de puissance (1) selon la revendication 1,
dans lequel le corps métallique mis en forme (70) est partiellement intégré dans une douille en matière plastique (76).
